# EUROPEAN PATENT APPLICATION

(11) **EP 4 618 159 A1**
(43) Date of publication of application: **17.09.2025**
(21) Application number: 23909132.5
(22) Date of filing: 20.07.2023
(51) Int. Cl.: H01L 29/78, H01L 29/41, H01L 21/336

(54) **LDMOS DEVICE**

(30) Priority: 28.12.2022 CN 202211697140; 28.12.2022 CN 202211698844
(71) Applicant: Suzhou Watech Electronics Co., Ltd., Suzhou, Jiangsu 215125 (CN)
(72) Inventor: WANG, Changchang, Suzhou, Jiangsu 215125 (CN); YUE, Dancheng, Suzhou, Jiangsu 215125 (CN)
(74) Representative: Michalski Hüttermann & Partner Patentanwälte mbB
(86) International application number: PCT/CN2023/108458
(87) International publication number: WO 2024/139189

(57) **Abstract**

The present disclosure provides an LDMOS device. The LDMOS device comprises a substrate structure; a drift region, located in the substrate structure in a vertical direction; a field plate structure, located above the substrate structure in the vertical direction, and projection of a part of the field plate structure in the substrate structure covering a part of the drift region; and a drain region, located in the substrate structure in the vertical direction, wherein at least some of electric field lines of the drain region connected to a high voltage are concentrated in the field plate structure and end in the field plate structure.

## Description

This application claims priority to Chinese Patent Application No. CN202211698844.9, filed on December 28, 2022, titled "LDMOS terminal structure and manufacturing method of LDMOS terminal structure" and Chinese Patent Application No. CN202211697140.X, filed on December 28, 2022, titled "SiC-LDMOS device", the contents of which are incorporated herein by reference in their entirety.

### TECHNICAL FIELD

The present disclosure relates to a semiconductor power device, more particularly to an LDMOS device.

### BACKGROUND

LDMOS (Laterally Diffused Metal Oxide Semiconductor) is currently widely used in industrial equipment, scientific instruments, medical devices, and other infrastructure that support social development and daily life. For a high-voltage LDMOS device, a reasonable terminal design is of great significance to ensure the high breakdown voltage of the device and improve the robustness of the device.

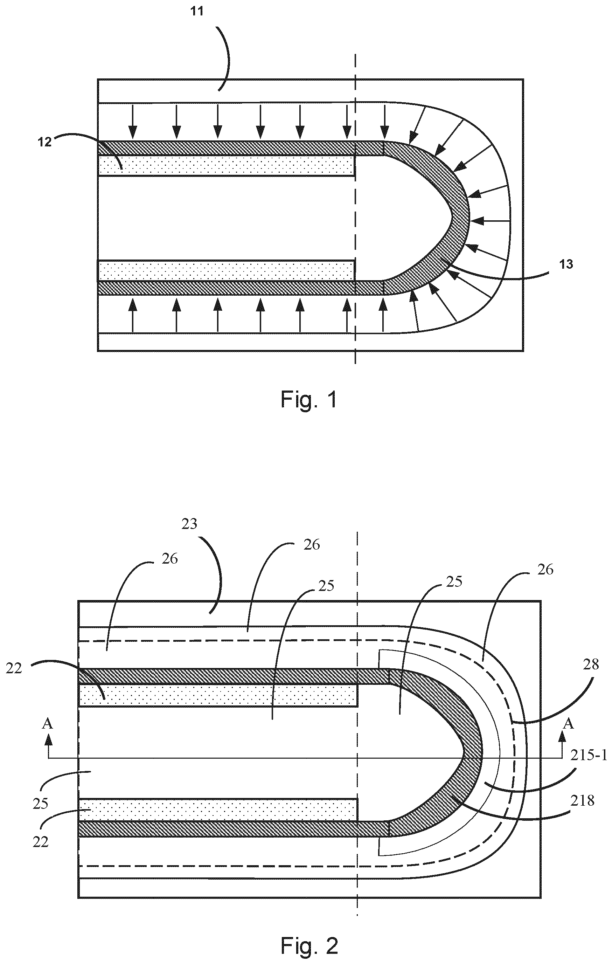

A top view of a conventional SiC-LDMOS device, as shown in Fig. 1, shows that the left side of the dotted line is the intrinsic region, and the right side of the dotted line is the termination region. The source region forms the intrinsic region. The gate surrounds the end of the source region. The drain region surrounds the end of the gate at the termination region. The electric field lines in the drain region at the termination region are concentrated inward, that is, the electric field lines are concentrated to the gate, resulting in a higher electric field intensity in the termination region than the intrinsic region, which will cause the actual breakdown voltage of the termination region of the SiC-LDMOS device to be much smaller than the actual breakdown voltage of the intrinsic region, which will cause the termination region of the SiC-LDMOS device to break down earlier than the intrinsic region, thus making the actual breakdown voltage BV of the SiC-LDMOS device lower. The electric field strength of the SiC-LDMOS device is much higher than the electric field strength of the Si-LDMOS device. Therefore, there is an urgent need to solve the technical problem that the termination region breakdown earlier than the intrinsic region of the conventional SiC-LDMOS device.

In addition, there are three mainstream solutions for the layout design of high-voltage LDMOS device, which are divided into circular layout, running-track layout and interdigital layout. The circular layout and running-track layout are mainly aimed at high-voltage devices with a low passing current. For LDMOS device that need a large passing current, due to the large overall gate length, the interdigital layout is generally used, thus introducing a drain-wrapping-source structure at the interdigital terminal. Because a high voltage is applied to the drain surrounding the source, and the electric field lines are concentrated and point to the source, which makes the electric field collect, resulting in early breakdown here, making the breakdown voltage of the LDMOS device low, resulting in the breakdown voltage of the whole LDMOS device not reaching the ideal design value. Therefore, for high-voltage LDMOS device, especially LDMOS device with the interdigital layout and the high-current operation requirements. Therefore, how to ensure that the breakdown voltage of the above-mentioned LDMOS device is high, to increase the breakdown voltage here, so as to ensure the robustness of high-voltage LDMOS, is also an urgent problem to be solved in the field of research on LDMOS device.

### SUMMARY

The main object of the present disclosure is to provide an LDMOS device to solve the above-described technical problems.

According to one aspect of the embodiment of the present disclosure, an LDMOS device is provided and comprises: a substrate structure; a drift region located in the substrate structure in a vertical direction; a field plate structure located above the substrate structure in the vertical direction, a projection of a part of the field plate structure in the substrate structure covering a part of the drift region; and a drain region located in the substrate structure in the vertical direction. At least part of electric field lines of the drain region connected to a high voltage concentrate toward the field plate structure and terminate at the field plate structure.

Optionally, the field plate structure is used to prevent a decrease in a voltage-bearing effect of the epitaxial layer lateral voltage-bearing region.

Optionally, the drain region is formed outside the drift region in a lateral direction, and the LDMOS device further comprises a gate electrode located above the substrate structure in the vertical direction and crossing an intrinsic region and a termination region of the LDMOS device in the lateral direction; and a dielectric layer being an insulating dielectric filled between the gate electrode and the drain region. The drift region is formed outside an outer edge of the gate electrode in the lateral direction and crosses the intrinsic region and the termination region. The field plate structure bridges over the gate electrode and the drift region respectively in the vertical direction, surrounds an outer edge of the gate electrode, and crosses the intrinsic region and the termination region in the lateral direction.

Optionally, the substrate structure comprises: a substrate; an epitaxial layer located on the substrate, where the drift region is formed within the epitaxial layer, the drift region and an outer edge of the gate electrode keep distance therebetween, to expose an epitaxial layer lateral voltage-bearing region, the epitaxial layer lateral voltage-bearing region is a part of the epitaxial layer located between the gate electrode and the drift region. The LDMOS device further comprises a source region formed within the epitaxial layer in the vertical direction, and a first end side of the source region is defined as a boundary between the intrinsic region and the termination region. The epitaxial layer lateral voltage-bearing region and the outer edge of the source region keep distance therebetween, so that the epitaxial layer lateral voltage-bearing region is only located in the termination region and does not enter the intrinsic region, a side of the epitaxial layer lateral voltage-bearing region away from the source region is located below the field plate structure, and the drift region and the drain region are formed within the epitaxial layer.

Optionally, the gate electrode is shaped as a running track. The epitaxial layer lateral voltage-bearing region is shaped as a running track surrounding the outer edge of the gate electrode located at the termination region. The drift region surrounds the gate electrode and an outer edge of the epitaxial layer lateral voltage-bearing region.

Optionally, the field plate structure comprises a first field plate shaped as Z, an upper lateral arm of the first field plate is disposed at intervals from an upper surface of the gate electrode, a vertical arm of the first field plate is disposed at intervals from the gate electrode, and a lower lateral arm of the first field plate is disposed at intervals from an upper surface of the drift region.

Optionally, the field plate structure further comprises a second field plate shaped as Z, and an upper lateral arm of the second field plate is disposed at intervals above the upper lateral arm of the first field plate in a partially stacked manner.

Optionally, the LDMOS device further comprises: a first layer body region and a second layer body region formed from top to bottom, and doping concentrations of the first layer body region and the second layer body region are sequentially increased from top to bottom; and a body region contact region, where the body region contact region, the source region, and the first layer body region are disposed in same layer in the lateral direction, and the second layer body region is formed below the body region contact region, the source region, and the first layer body region in the vertical direction.

Optionally, the LDMOS device further comprises a drift buffer region located within the drift region in the vertical direction and surrounding the drain region.

Optionally, the LDMOS device further comprises: a backside metal formed on a lower surface of the substrate; two first metal layers, one above the source region and one above the drain region; a first via hole and a metal filled in the first via hole connecting the source region, the body region contact region, and the first metal layer above the source region; a second via hole and a metal filled in the second via hole connecting the drain region and the first metal layer above the drain region; and a third via hole and a metal filled in the third via hole connecting the backside metal, the substrate, the epitaxial layer, the second layer body region and the first metal layer above the source region.

Optionally, the LDMOS device further comprises a fourth via hole and a metal filled in the fourth via hole connecting the first metal layer located above the source region and the upper lateral arm of the first field plate, where the upper lateral arm of the first field plate is disposed at intervals from the upper surface of the gate electrode, the vertical arm of the first field plate is disposed at intervals from the gate electrode, and the lower lateral arm of the first field plate is disposed at intervals from the upper surface of the drift region.

Optionally, the gate electrode, the source region, and the drain region are located in a same plane.

Optionally, the substrate structure comprises a substrate and an epitaxial layer, and the epitaxial layer is located on a surface of the substrate. The LDMOS device further comprises a third layer body region, the third layer body region and the drift region are disposed at intervals within the epitaxial layer, doping types of the epitaxial layer and the third layer body region are same, doping types of the drift region and the epitaxial layer are different, and a doping concentration of the drift region is larger than a doping concentration of the epitaxial layer. The field plate structure comprises a field plate main portion and an arc field plate located on one side of the field plate main portion, the field plate main portion is in contact with the arc field plate, the field plate structure has a fifth via hole, the fifth via hole is located between the field plate main portion and the arc field plate, a projection of the arc field plate in the epitaxial layer covers a part of the drift region, and a projection of the epitaxial layer between the third layer body region and the drift region in the field plate structure is located in the fifth via hole.

Optionally, the drain region is located in the drift region, a surface of the drain region away from the substrate is even with a surface of the drift region away from the substrate, a doping type of the drain region is the same as the doping type of the drift region, and the LDMOS device further comprises: a source region located within the body region, a surface of the source region away from the substrate being even with a surface of the epitaxial layer away from the substrate, and doping types of the source region and the body region are different; a source electrode located on a partial surface of the source region away from the substrate; and a drain electrode located on a partial surface of the drain region away from the substrate.

Optionally, the LDMOS device further comprises: a gate oxide layer located on a partial surface of the epitaxial layer, the gate oxide layer covering a part of the body region and a part of the epitaxial layer, and the gate oxide layer not in contact with the source region; a gate electrode located on a surface of the gate oxide layer away from the epitaxial layer, projections of the gate oxide layer and the gate electrode in the field plate structure located in the fifth via hole; a dielectric layer covering the gate oxide layer, the gate electrode, and a surface of the epitaxial layer away from the substrate, where a surface of the dielectric layer away from the epitaxial layer is planar, the source electrode and the drain electrode penetrate the dielectric layer, and the field plate structure is located on the surface of the dielectric layer away from the substrate.

Optionally, the epitaxial layer is located on a partial surface of the substrate, the LDMOS device further comprises: a second metal layer located on another partial surface of the substrate, and a surface of the second metal layer away from the substrate is even with a surface of the dielectric layer away from the substrate, the second metal layer electrically connects the source region and the substrate, and the field plate structure is in contact with the second metal layer.

Optionally, the LDMOS device further comprises a third metal layer located on a partial surface of the dielectric layer away from the substrate, the third metal layer is in contact with the drain electrode, the third metal layer is disposed at intervals from the field plate structure, and the third metal layer and the field plate structure expose a part of the dielectric layer.

Optionally, the doping type of the epitaxial layer is P-type, and the doping type of the drift region is N-type.

According to the technical solution of the present disclosure, the following technical effects can be achieved:
1) The field plate structure is not only disposed within the intrinsic region, but also within the termination region. And the field plate structure bridges above the gate electrode and the drift region in the vertical direction respectively. In this way, the electric field lines of the drain region connected to the high voltage are concentrated toward the field plate structure, and no matter within the termination region or the intrinsic region terminate, all terminate at the field plate structure, and the electric field lines are reduced by a small distance in the termination region, so that the risk of breakdown of the first oxide layer is small. Also, the difference of reduced distance between the electric field lines in the termination region and the intrinsic region is small, so that the difference between the electric field intensity of the termination region and the electric field intensity of the intrinsic region is small, and then the difference between the actual breakdown voltage of the termination region and the actual breakdown voltage of the intrinsic region is small, so that the termination region of the SiC-LDMOS device will not be broken down in advance, and then the actual breakdown voltage BV of the SiC-LDMOS device is high.
2) By providing the base comprising the substrate, the epitaxial layer, the body region, and the drift region. Further, the LDMOS device comprises the field plate structure, and the field plate structure comprises the field plate main body and the arc field plate. Since the projection of the arc field plate in the substrate covers a part of the drift region, the electric field distribution in the drift region can be optimized by the field plate structure. Further, since the projection of the epitaxial layer between the body region and the drift region in the field plate structure is located in the first via hole, that is, the field plate structure makes a part of the epitaxial layer hollowed out, so that the field plate structure has less influence on the electric field of the epitaxial layer, thereby optimizing the electric field distribution of the LDMOS device, ensuring a high breakdown voltage of the LDMOS device, and ensuring better performance of the semiconductor device.

### BRIEF DESCRIPTION OF THE DRAWINGS

The accompanying drawings, which constitute a part of the present disclosure, are used to provide a further understanding of the present disclosure, and the schematic embodiments of the present disclosure and the description thereof are used to explain the present disclosure, and do not constitute an undue limitation of the present disclosure. In the drawings:
Fig. 1 is a top view of a conventional SiC-LDMOS device.
Fig. 2 is a top view of a SiC-LDMOS device according to an embodiment of the present disclosure.
Fig. 3 is a cross-sectional view taken along line A-A of Fig. 12.
Fig. 4 is a schematic structural diagram according to an embodiment of the present disclosure, after forming a preliminary gate electrode.
Fig. 5 is a schematic structural diagram according to the embodiment of the present disclosure, after forming a gate oxide layer and a gate electrode.
Fig. 6 is a schematic structural diagram according to the embodiment of the present disclosure, after forming a base by injection.
Fig. 7 is a schematic structural diagram according to the embodiment of the present disclosure, after forming a preliminary dielectric layer.
Fig. 8 is a schematic structural diagram according to the embodiment of the present disclosure, after forming a second via hole, a third via hole, and a fourth via hole.
Fig. 9 is a schematic structural diagram according to the embodiment of the present disclosure, after forming a source electrode, a drain electrode, and a first metal layer.
Fig. 10 is a structural schematic diagram according to the embodiment of the present disclosure, after forming a preliminary field plate structure.
Fig. 11 is a schematic structural diagram of the LDMOS device according to the embodiment of the present disclosure.
Fig. 12 is a top view of the LDMOS device according to the embodiment of the present disclosure.
Fig. 13 is a schematic flowchart of a manufacturing method of the LDMOS device according to the embodiment of the present disclosure.

### REFERENCES IN THE DRAWINGS:

10 base; 20 field plate structure; 30 gate oxide layer; 40 gate electrode; 50 dielectric layer; 60 second metal layer; 70 third metal layer; 80 preliminary gate oxide layer; 90 preliminary gate electrode; 100 preliminary dielectric layer; 101 substrate; 102 epitaxial layer; 103 third layer body region; 104 drift region; 105 source region; 106 drain region; 107 source electrode; 108 drain electrode; 110 sixth via hole; 120 seventh via hole; 130 eighth via hole; 140 preliminary field plate structure; 201 field plate main portion; 202 arc field plate; 203 fifth via hole; 21 gate oxide layer; 22 source region; 23 drain region; 24 first layer body region; 25 body region contact region; 26 drift region; 27 drift buffer region; 28 first field plate; 29 fourth via hole; 210 first metal layer; 211 first via hole; 212 second via hole; 213 third via hole; 214 second layer body region; 215 epitaxial layer; 215-1 epitaxial layer lateral voltage-bearing region; 216 first doping type substrate; 217 backside metal; 218 gate electrode.

### DETAILED DESCRIPTION OF THE EMBODIMENTS

The embodiments of the present disclosure and the features of the embodiments can be combined with each other unless there is a conflict. Hereinafter, the present disclosure will be described in detail with reference to the accompanying drawings in conjunction with embodiments.

In order to enable those skilled in the art to better understand the solutions of the present disclosure, the technical solutions in the embodiments of the present disclosure will be clearly and completely described below with reference to the accompanying drawings in the embodiments of the present disclosure, and it is obvious that the described embodiments are only some embodiments of the present disclosure, but not all embodiments. Based on the embodiments in the present disclosure, all other embodiments obtained by those skilled in the art without inventive work should belong to the scope of protection of the present disclosure.

It should be noted that the terms "first", "second", and the like in the specification, claims, and drawings of the present disclosure are used to distinguish similar elements, and are not necessarily used to describe a specific order or sequence. It should be understood that the data so used can be interchangeable where appropriate in order to facilitate the embodiments of the present disclosure described herein. Furthermore, the terms "comprise" and "have" and any variations thereof are intended to cover a non-exclusive inclusion, for example, process, method, system, product, or device comprising a series of steps or units is not necessarily limited to those steps or units clearly listed, but can comprise other steps or units not clearly listed or inherent to such process, method, or device.

It should be understood that when an element, such as a layer, film, region, or substrate, is described as being "on/at" another element, the element can be directly on the other element, or intervening elements can also be present. Furthermore, in the specification and claims, when an element is described as "connected" to another element, the element can be "directly connected" to the other element, or "connected" to the other element through a third element.

In order to solve the technical problems mentioned in the background, in an exemplary embodiment of the present disclosure, an LDMOS device is provided.

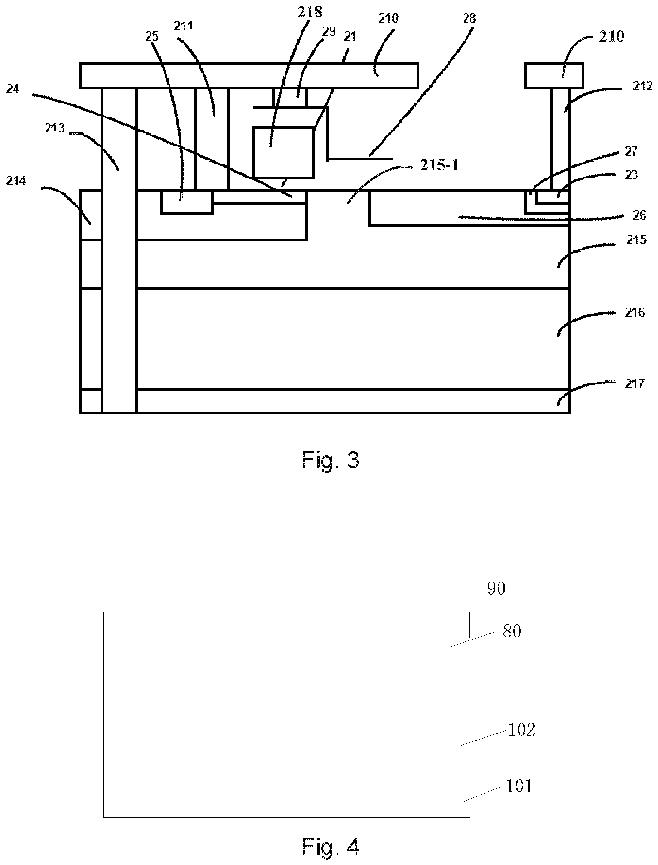

As shown in Figs. 2 and 3, a SiC-LDMOS device according to an embodiment of the present disclosure comprises:
a substrate;
a gate electrode 218 located above the substrate in the vertical direction and crossing the intrinsic region and the termination region of the SiC-LDMOS device in the lateral direction, where in Fig. 2, the left side of the dotted line is the intrinsic region, and the right side of the dotted line is the termination region;
a drift region 26 located within the substrate in the vertical direction and formed outside the outer edge of the gate electrode 218 in the lateral direction and crossing the intrinsic region and the termination region;
a drain region 23 formed in the substrate in the vertical direction and outside the drift region 26 in the lateral direction;
a dielectric layer being an insulating dielectric filling between all the semiconductors and metals between the gate electrode 218 and the drain region 23; and
a field plate structure bridging above the gate electrode 218 and the drift region 26 in the vertical direction respectively, and surrounding an outer edge of the gate electrode 218 in the lateral direction, and crossing the intrinsic region and the termination region;
where the electric field lines of the drain region connected to a high voltage concentrate toward the field plate structure and terminate at the field plate structure.

In the SiC-LDMOS device according to the embodiment of the present disclosure, the field plate structure is not only provided in the intrinsic region, but also provided in the termination region. And the field plate structure respectively bridges above the gate electrode 218 and the drift region 26 in the vertical direction. Thus, the electric field lines of the drain region connected to the high voltage are concentrated toward the field plate structure, and no matter within the termination region or the intrinsic region terminate, all terminate at the field plate structure, and the electric field lines are reduced by a small distance in the termination region, so that the risk of breakdown of the first oxide layer is small. Also, the difference of reduced distance between the electric field lines in the termination region and the intrinsic region is small, so that the difference between the electric field intensity of the termination region and the electric field intensity of the intrinsic region is small, and then the difference between the actual breakdown voltage of the termination region and the actual breakdown voltage of the intrinsic region is small, so that the termination region of the SiC-LDMOS device will not be broken down in advance, and then the actual breakdown voltage BV of the SiC-LDMOS device is high.

Specifically, the vertical direction is the thickness direction of the SiC-LDMOS device, corresponding to the up-down direction in Fig. 3. The lateral direction is the direction of the plane perpendicular to the vertical direction, corresponding to the direction perpendicular to the paper surface in Fig. 3.

Specifically, the substrate is a silicon carbide (SiC) substrate, and the gate electrode 218 is a polysilicon gate electrode.

Specifically, as shown in Fig. 3, the gate oxide layer 21 is formed below the gate electrode 218. The gate oxide layer 21 is a silicon dioxide gate oxide layer 21, and the gate oxide layer 21 is an insulating dielectric between a semiconductor defined as a source region 22 and a metal defined as a gate electrode 218. The gate oxide layer 21 is a part of the dielectric layer. The field plate structure is further a metal structure, and an insulating dielectric is further formed around the field plate structure. The dielectric layer further comprises an insulating dielectric filled between the drain region 23 and the first metal layer 210. That is, the dielectric layer is filled between all of the semiconductors and metals between the gate electrode 218 and the drain region 23.

In implementation, the gate electrode 218, the source region 22, and the drain region 23 are located in the same plane. That is, the SiC-LDMOS device according to the embodiment of the present disclosure is a SiC-LDMOS device having a planar structure. It is particularly adapted for SiC-LDMOS devices with high-voltage planar structures.

In implementation, as shown in Figs. 2 and 3, a lower portion of the substrate forms a first doping type substrate 216, and an upper portion of the substrate forms an epitaxial layer 215 of the first doping type. The drift region 26 is formed in the epitaxial layer, and the drift region 26 and the outer edge of the gate electrode 218 keep distance therebetween to expose an epitaxial layer lateral voltage-bearing region 215-1, and the epitaxial layer lateral voltage-bearing region 215-1 is a part of the epitaxial layer located between the gate electrode 218 and the drift region 26.

The SiC-LDMOS device further comprises:
a source region 22 formed in the epitaxial layer in a vertical direction, where a first end side of the source region 22 is defined as a boundary between the intrinsic region and the termination region.

The epitaxial layer lateral voltage-bearing region 215-1 and the outer edge of the source region 22 keep distance therebetween, so that the epitaxial layer lateral voltage-bearing region 215-1 is only located in the termination region and does not enter the intrinsic region, the side of the epitaxial layer lateral voltage-bearing region 215-1 facing the drain region is located below the field plate structure, and the drift region and the drain region are formed within the epitaxial layer.

The epitaxial layer lateral voltage-bearing region is only located in the termination region and does not enter the intrinsic region. Corresponding to Fig. 2, the reason why the left side of the epitaxial layer lateral voltage-bearing region 215-1 does not enter the intrinsic region is that if the epitaxial layer lateral voltage-bearing region enters the intrinsic region, the on-resistance of the SiC-LDMOS device will be increased. It is recommended that the source region not enter the annular region of the termination region. If it enters the annular region of the termination region, the termination region will also be conducted when the SiC-LDMOS device is operating. The requirement of the termination region is that it is not conducted and only bears the voltage.

The side of the epitaxial layer lateral voltage-bearing region away from the source region is located below the field plate structure, that is, the edge of the field plate structure in the direction of the drain region covers the epitaxial layer lateral voltage-bearing region. In this way, the breakdown voltage of the termination region of the SiC-LDMOS device is further increased. The principle is to use the strong junction electric field of the PN junction formed by the epitaxial layer lateral voltage-bearing region and the drift region to raise the electric field strength in the area near the PN junction, thereby further improving the voltage-bearing capacity of the termination region of the SiC-LDMOS device.

The field plate structure is used to prevent a decrease in the voltage-bearing effect of the epitaxial layer lateral voltage-bearing region.

The shape of the drift region does not surround the outer edge of the entire gate electrode, but the drift region is not formed at the position of the epitaxial layer lateral voltage-bearing region, but a part of the epitaxial layer is exposed. That is, the shape of the drift region in the termination region is a specific shape. As an additional terminal voltage-bearing area, the epitaxial layer lateral voltage-bearing region can bear more voltage and laterally form a PP-N-N graded junction, that is, the body region contact region/epitaxial layer lateral voltage-bearing region/drift buffer region/drain region, which is conducive to smoothing the electric field distribution and solving the problem of BV reduction caused by the electric field concentration effect in the termination region. The principle is that the junction electric field of the abrupt PN junction is very strong, and the SiC-LDMOS device can preferentially break down at the junction interface. The reason why the epitaxial layer lateral voltage-bearing region cannot extend beyond the edge of the field plate structure in the direction of the drain region is that if it extends beyond the field plate structure, in this case, the PN junction electric field will produce a strong electric field concentration at the right angle edge with the drift region, since there is no field plate structure to disperse the electric field lines, and the device can break down here very early. However, the lateral voltage-bearing area within the edge of field plate structure, and the electric field intensity of PN junction interface is basically not higher than that at the edge of field plate structure.

In implementation, as shown in Fig. 2, the part of the gate electrode 218 located in the termination region is semi-annular.

The epitaxial layer lateral voltage-bearing region 215-1 is semi-annular and surrounds the outer edge of the gate electrode 218 located in the termination region.

The drift region 26 surrounds the outer edge of the gate electrode 218 and the epitaxial lateral voltage-bearing region 215-1.

The part of the gate electrode 218 located in the termination region is semi-annular, and the epitaxial layer lateral voltage-bearing region 215-1 is semi-annular. The semi-annular structure can effectively alleviate the electric field concentration effect at the edge of the gate electrode in the termination region. The principle is similar to that of point discharge. The sharper the structure, the easier it is to produce charge concentration under the induction of external high potential, and the generated high electric field can break down the dielectric here. The semi-annular structure can effectively alleviate the charge concentration of point discharge, which makes it more difficult for the dielectric at the termination to be broken down or undergo semiconductor avalanche breakdown.

As shown in Figs. 2 and 3, the field plate structure comprises:
a first field plate 28 shaped as Z, an upper lateral arm of the first field plate disposed at intervals from the upper surface of the gate electrode 218, a vertical arm of the first field plate disposed at intervals from the gate electrode, and a lower lateral arm of the first field plate 28 disposed at intervals from the upper surface of the drift region 26.

The first field plate 28 disperses the high electric field strength at the edge of the gate, reduces the risk of breakdown of the dielectric layer, and improves the reliability of the dielectric layer.

In implementation, the field plate structure further comprises:
a second field plate shaped as Z, an upper lateral arm of the second field plate disposed at intervals above the upper lateral arm of the first field plate so as to be partially stacked.

The first field plate and the second field plate, in this multi-layer field plate manner, disperse the high electric field strength at the edge of the gate, reduce the risk of breakdown of the dielectric layer, and improve the reliability of the dielectric layer.

In implementation, the SiC-LDMOS device further comprises:
a first layer body region 24 and a second layer body region 214 formed from top to bottom, where the doping concentrations of the first layer body region 24 and the second layer body region 214 increase sequentially from top to bottom; and
a body region contact region 25, where the body region contact region 25, the source region and the first layer body region are provided in the same layer in the lateral direction, and the second layer body region 214 is formed below the body region contact region 25, the source region and the first layer body region in the vertical direction.

The location between the source region and the drain region, and below the gate electrode, is the location of the trench. The first layer body region 24 and the second layer body region 214 are formed from top to bottom at the location of the trench. Moreover, the doping concentrations of the first layer body region 24 and the second layer body region 214 increase sequentially from top to bottom, that is, the doping concentration of the first layer body region 24 is lower and the doping concentration of the second layer body region 214 is higher. Since the doping concentration of the first layer body region 24 is lower, the threshold voltage Vt can be realized within a reasonable range by adjusting the doping concentration of the first layer body region 24. The first layer body region 24, having a lower doping concentration, avoids further decrease in mobility due to carrier scattering caused by trench doping, thereby improving trench mobility. The higher doping concentration of the second layer body region 214 makes the electric field strength of the pn junction (the pn junction formed by the structure between the source region, the source region and the drain region) lower at the trench edge under high voltage, and the depletion region is not excessively broadened to the source region of the second doping type, so that the expansion of the depletion region is limited, so that the short trench does not penetrate at high voltage, and the breakdown voltage BV is increased.

In implementation, as shown in Fig. 3, the SiC-LDMOS device further comprises:
a drift buffer region 27 located within the drift region 26 in the vertical direction and surrounds the drain region 23.

In implementation, as shown in Fig. 3, the SiC-LDMOS device further comprises:
a backside metal 217 formed on a lower surface of the first doping type substrate 216;
two first metal layers 210, one above the source region and one above the drain region;
a first via hole 211 and a metal filled in the first via hole connecting the source region, the body region contact region, and the first metal layer above the source region;
a second via hole 212 and a metal filled in the second via hole connecting the drain region and the first metal layer above the drain region; and
a third via hole 213 and a metal filled in the third via hole connecting the backside metal 217, the first doping type substrate 216, the epitaxial layer 215, the second layer body region 214 and the first metal layer above the source region.

In implementation, as shown in Fig. 3, the SiC-LDMOS device further comprises:
a fourth via hole 29 and a metal filled in the fourth via hole. The upper lateral arm of the first field plate 28 is disposed at intervals from the upper surface of the gate electrode, a vertical arm of the first field plate 28 is disposed at intervals from the gate electrode, and a lower lateral arm of the first field plate 28 is disposed at intervals from the upper surface of the drift region.

In implementation, as shown in Fig. 3, the gate electrode 218, the source region 22, and the drain region 23 are located in the same plane. The source region is grounded, the drain region is connected to the operating voltage, and different voltages are applied to the gate electrode to control the switching of the device.

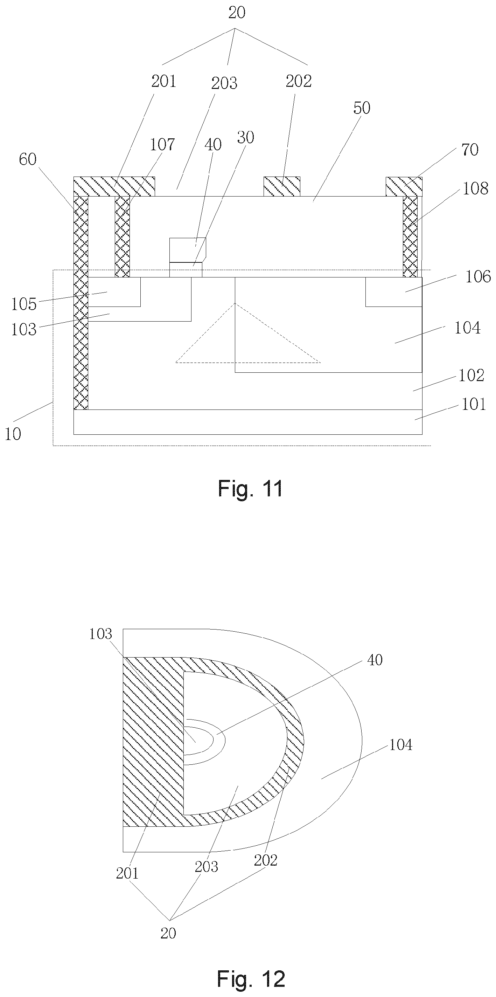

According to one aspect of the present disclosure, there is further provided an LDMOS device, as shown in Figs. 11 and 12, comprising a base 10 and a field plate structure 20. The base 10 comprises a substrate 101, an epitaxial layer 102, a third layer body region 103, and a drift region 104. The epitaxial layer 102 is located on the surface of the substrate 101. The third layer body region 103 is disposed at intervals with the drift region 104 within the epitaxial layer 102. The doping types of the epitaxial layer 102 and the third layer body region 103 are the same. The doping type of the drift region 104 is different from the doping type of the epitaxial layer 102, and the doping concentration of the drift region 104 is higher than the doping concentration of the epitaxial layer 102. The field plate structure 20 is located on the side of the epitaxial layer 102 away from the substrate 101. The field plate structure 20 comprises a field plate main portion 201 and an arc field plate 202 located on one side of the field plate main portion 201. The field plate main portion 201 is in contact with the arc field plate 202. The field plate structure 20 comprises a fifth via hole 203 located between the field plate main portion 201 and the arc field plate 202. The projection of the arc field plate 202 in the epitaxial layer 102 covers a part of the drift region 104. The projection of the field plate main portion 201 in the epitaxial layer 102 covers a part of the third layer body region 103. The projection of the epitaxial layer 102 between the third layer body region 103 and the drift region 104 relative to the field plate structure 20 is located in the fifth via hole 203.

The LDMOS device comprises a base and a field plate structure, and the base comprises a substrate, an epitaxial layer, a third layer body region, and a drift region. The epitaxial layer is stacked on the substrate, and the third layer body region, and the drift region are provided at intervals within the epitaxial layer. The doping types of the epitaxial layer and the third layer body region are the same. The doping type of the drift region is different from the doping type of the epitaxial layer, and the doping concentration of the drift region is higher than the doping concentration of the epitaxial layer. The field plate structure is located on a side of the epitaxial layer away from the substrate, and the field plate structure comprises a field plate main body and an arc field plate located on one side of the field plate main portion. The field plate main portion is in contact with the arc field plate, the field plate structure has a fifth via hole, and the fifth via hole is surrounded by the field plate main portion and the arc field plate. The projection of the arc field plate in the epitaxial layer covers a part of the drift region. The projection of the field plate main portion in the epitaxial layer covers a part of the third layer body region. The projection of the epitaxial layer between the third layer body region and the drift region relative to the field plate structure is located in the fifth via hole. Comparing with the conventional art having poor performance because of low breakdown voltage, the LDMOS device according to the present disclosure provides the base comprising the substrate, the epitaxial layer, the third layer body region, and the drift region, and further comprises the field plate structure, and the field plate structure comprising the field plate body and the arc field plate. Since the projection of the arc field plate in the epitaxial layer covers a part of the drift region, the electric field distribution in the drift region can be optimized by the field plate structure. In addition, since the projection of the epitaxial layer between the third layer body region and the drift region relative to the field plate structure is located in the fifth via hole, that is, the field plate structure hollows out a part of the epitaxial layer, the field plate structure has less influence on the electric field of the epitaxial layer, which further optimizes the electric field distribution of the LDMOS device, ensures that the breakdown voltage of the LDMOS device is higher, and further ensures that the performance of the semiconductor device is better.

Further, since the third layer body region and the drift region are disposed at intervals, and the doping concentration of the drift region is larger than the doping concentration of the epitaxial layer, the epitaxial layer having a relatively small concentration exists between the third layer body region and the drift region. Moreover, the doping types of the epitaxial layer and the drift region are different, so that a reverse PN junction is formed between the epitaxial layer and the drift region, and the reverse PN junction can bear the voltage, thereby ensuring that the electric field distribution of the semiconductor device is better, the breakdown voltage of the semiconductor device is higher, and the performance of the semiconductor device is better.

Specifically, the modulation principle of the field plate on the breakdown voltage and the electric field of the surface of the drift region is described as follows: as shown in Fig. 11, in a case where the doping types of the epitaxial layer 102, the third layer body region 103, and the source region 105 are P-type, and the doping type of the drift region 104 and the drain region 106 is N-type, and when the entire device is applied with an external breakdown voltage, the electrode corresponding to the drain electrode 108 is applied with a positive voltage, and the electrodes corresponding to the source electrode 107 and the second metal layer 60 are short-circuited and grounded. In this case, the drain electrode 108 is applied with a positive voltage, and the electrons in the N region are concentrated toward the high potential region of the drain region 106. Similarly, the holes in the P region are concentrated toward the low potential region of the source region 105. The depletion region at the junction interface formed by the epitaxial layer 102 and the drift region 104 is expanded until the spatial integral of the electric field formed by the fixed charges in the depletion region is equal to the applied external voltage, and the depletion region stops being expanded. At this time, the PN junction reaches a reverse bias balanced state at a certain voltage. It is not difficult to understand that the strongest electric field intensity of the whole reverse bias junction should be at the junction interface, and under the ideal condition of uniform doping, the electric field intensity should decrease linearly along the junction interface to the boundary of the depletion region. The electric field strength on two sides of the junction interface forms a triangle (as shown in Fig. 11, the triangular dotted line), and the area (integral) of the triangle is the reverse bias voltage that the reverse bias junction can bear. Specifically, Fig. 11 shows a schematic diagram illustrating that the electric field strengths of the N-type region of the drift region 104 and the P-type region of the epitaxial layer 102 are distributed to two sides along the vertical junction interface. After introducing the grounded field plate (the field plate main portion 201 and the arc field plate 202), it can be assumed that the field plate gradually approaches the drain electrode as a low potential point, which can force to concentrate the electron in the drain region 106, that is, assist the depletion of the undepleted region near the drain region 106. Correspondingly, the vertex of the triangular electric field located in the drift region 104 will move to the right, so that the triangular area is increased, and the bearing voltage of the LDMOS device is increased. Also, adjusting the height of the field plate, that is, the distance close to the N region, can increase the electric field intensity at the corresponding position of the N region, that is, the edge of the triangular electric field close to the drain region 106 will protrude, and the bearing voltage of the device is also increased. However, the field plate will cover the P-type region while crossing the PN junction interface from the drain region 106 to above the N-type region, which leads to a decrease in the bearing voltage of the P-type region. In the LDMOS device of the present disclosure, the field plate can suppress the effect of the field plate on the decrease of the electric field in the P-type region by hollowing out the field plate, and further ensure that the electric field in the P-type region does not decrease excessively in a case increasing the electric field in the N-type region, thereby ensuring that the reverse bias PN junction breakdown voltage of the device provided with the hollowed-out field plate is high.

According to the embodiment of the present disclosure, as shown in Figs. 11 and 12, the base 10 further comprises a source region 105, a drain region 106, a source electrode 107, and a drain electrode 108. The source region 105 is located within the third layer body region 103. The surface of the source region 105 away from the substrate 101 is even with the surface of the epitaxial layer 102 away from the substrate 101. The doping types of the source region 105 and the third layer body region 103 are different. The drain region 106 is located within the drift region 104. The surface of the drain region 106 away from the substrate 101 is even with the surface of the drift region 104 away from the substrate 101. The doping type of the drain region 106 is the same as the doping type of the drift region 104. The source electrode 107 is located on a partial surface of the source region 105 away from the substrate 101. The drain electrode 108 is located on a partial surface of the drain region 106 away from the substrate 101. Since the base further comprises the source region, the drain region, the source electrode, and the drain electrode, the source electrode can be leaded out through the source region, and the drain electrode can be leaded out through the drain region, thereby ensuring that the performance of the LDMOS device can be achieved, and further ensuring that good performance of the LDMOS device.

According to another embodiment of the present disclosure, as shown in Figs. 11 and 12, the LDMOS device further comprises a gate oxide layer 30, a gate electrode 40, and a dielectric layer 50. The gate oxide layer 30 is located on a partial surface of the epitaxial layer 102. The gate oxide layer 30 covers a part of the third layer body region 103 and a part of the epitaxial layer 102, and the gate oxide layer 30 is not in contact with the source region 105. The gate electrode 40 is located on a surface of the gate oxide layer 30 away from the epitaxial layer 102. The projections of the gate oxide layer 30 and the gate electrode 40 relative to the field plate structure 20 are located in the fifth via hole 203. The dielectric layer 50 covers the gate oxide layer 30, the gate electrode 40, and the surface of the epitaxial layer 102 away from the substrate 101, and the surface of the dielectric layer 50 away from the epitaxial layer 102 is planar. The source electrode 107 and the drain electrode 108 penetrate the dielectric layer 50. The field plate structure 20 is located on the surface of the dielectric layer 50 away from the substrate 101. Since the LDMOS device further comprises the gate oxide layer, the gate electrode, and the dielectric layer, the performance of the LDMOS device can be realized through the gate electrode, and good performance of the LDMOS device is further ensured.

In the embodiment, as shown in Fig. 11, the surface area of the gate electrode 40 close to the base 10 is smaller than the surface area of the gate electrode 40 away from the base 10. That is, the angle of the gate electrode close to the substrate is not a right angle, so that the gate electrode optimizes the electric field of the base, and further ensures that the breakdown voltage of the semiconductor device is higher, and further ensures good performance of the semiconductor device.

In order to further ensure good performance of the LDMOS device, according to another embodiment of the present disclosure, the epitaxial layer is located on a part of the predetermined surface of the substrate. As shown in Figs. 11 and 12, the LDMOS device further comprises a second metal layer 60 located on another part of the predetermined surface of the substrate 101, and the surface of the second metal layer 60 away from the substrate 101 is even with the surface of the dielectric layer 50 away from the substrate 101. The second metal layer 60 electrically connects the source region 105 and the substrate 101. The field plate structure 20 is in contact with the second metal layer 60. Since the epitaxial layer is located on a part of the predetermined surface of the substrate, and the second metal layer is located on another part of the predetermined surface of the substrate, that is, the epitaxial layer is in contact with the second metal layer, and both are located on the substrate. Since the second metal layer electrically connects the source region and the substrate, the source region can be connected to the substrate through the second metal layer, that is, realizing grounded, further ensuring good performance of the LDMOS device.

Specifically, the predetermined surface is a surface of the substrate close to the epitaxial layer. The epitaxial layer is located on the partial surface of the substrate. The second metal layer is in contact with the epitaxial layer, and the second metal layer is located on another part of the predetermined surface of the substrate.

According to the embodiment of the present disclosure, as shown in Figs. 11 and 12, the LDMOS device further comprises a third metal layer 70. The third metal layer 70 is located on a partial surface of the dielectric layer 50 away from the base 10. The third metal layer 70 is in contact with the drain electrode 108. The third metal layer 70 and the field plate structure 20 are disposed at intervals, and the third metal layer 70 and the field plate structure 20 expose a part of the dielectric layer 50. Since the LDMOS device further comprises the third metal layer, and the third metal layer is in contact with the drain electrode, the drain region can be leaded out through the third metal layer and the drain electrode, that is, the drain electrode and the drain region can be connected through the third metal layer, thereby further ensuring good performance of the LDMOS device.

According to another embodiment of the present disclosure, the material of the field plate structure comprises aluminum. Of course, the structure of the field plate is not limited to aluminum, and other materials such as tungsten or copper can be selected, and is not limited here.

In order to further ensure good performance of the LDMOS device, according to another embodiment of the present disclosure, the doping type of the epitaxial layer is P-type, and the doping type of the drift region is N-type. Since the doping type of the epitaxial layer is P-type and the doping type of the drift region is N-type, that is, a reverse PN junction is formed between the epitaxial layer of P-type and the drift region of N-type, so that the formed reverse PN junction can bear voltage, optimization of the electric field distribution of the LDMOS terminal device is realized, high breakdown voltage of the LDMOS is ensured, and good performance of the LDMOS device is further ensured.

Specifically, the terminal withstand voltage structure of conventional LDMOS devices is generally a reverse PN junction formed between a P-heavy-doped region at source and an N-type drift region. At present, the main design idea of the terminal structure of this drain-wrap-source is to add a P-shallow-doped region between the P-heavy-doped region of the source and the N-drift region of the drain, so as to make the voltage-bearing PN junction of the entire terminal into a more graded PN junction to improve the withstand voltage value. Generally, considering the possibility of process realization, the P-shallow-doped region is generally defined by the P-type epitaxial layer itself. However, due to the difference in implantation concentration between the P-type epitaxial layer and N-type drift region, the electric field strength will decrease rapidly in the N-drift region, which limits the breakdown voltage of the LDMOS device from increasing. For the reverse PN junction, the surface electric field of the N-type region can be optimized by the field plate, thereby increasing the breakdown voltage. However, the design field plate penetration into the N-type region covers the P-type region. Due to the low potential of the field plate, the voltage equipotential line will be limited, which will cause the electric field intensity of the P-type region to decrease, and the terminal voltage bearing capacity will also decrease. In the LDMOS device of the present disclosure, by designing the field plate structure comprising the field plate main portion and the arc field plate, on the one hand, the terminal electric field distribution is optimized by the reverse PN junction formed between the P-type epitaxial layer and the N-type drift region, on the other hand, the arc field plate above the N-type drift region can optimize the electric field distribution in the drift region, and on yet another hand, the projection of the epitaxial layer between the third layer body region and the drift region relative to the field plate structure is located in the fifth via hole, that is, the part of the field plate structure corresponding to the P-type epitaxial layer is hollowed, so the field plate structure has less effect on the electric field of the P-type epitaxial layer, realizing the optimization of the electric field of the P-type epitaxial layer region, further ensuring high breakdown voltage of the LDMOS device, and further ensuring good performance of the LDMOS device.

In the embodiment, through the actual potential line distribution test of the conventional LDMOS device formed by the non-hollow field plate and the LDMOS device of the present disclosure comprising the hollow field plate, it can be concluded that although the field plate of the conventional LDMOS device can play a role in enhancing the electric field on the surface of the NLDD (N-type low doped drain region), the equipotential line is pinned by the zero potential field plate, so the P-type epitaxial region is reduced, and the complete voltage bearing capacity cannot be exerted. According to the actual test, the maximum bearing voltage of the conventional LDMOS device is 50 V. In the LDMOS device of the present disclosure, by providing the hollowed-out field plate structure, a part of the potential line at the drain terminal is released, so that the bearing voltage of the epitaxial layer is enhanced, and the enhancement effect of the field plate structure (i.e. the hollowed-out field plate) on the surface electric field of the NLDD does not decrease too much. In addition, the electric field intensity distribution diagrams of the LDMOS device of the present disclosure and the conventional LDMOS device are actually tested, and it is known through the test that the terminal bearing voltage of the hollow field plate structure of the LDMOS device is 59 V. Therefore, compared with the conventional design of the non-hollow field plate, the breakdown voltage of the LDMOS device of the present disclosure is effectively improved.

According to the embodiment of the present disclosure, a manufacturing method of the LDMOS device is further provided.

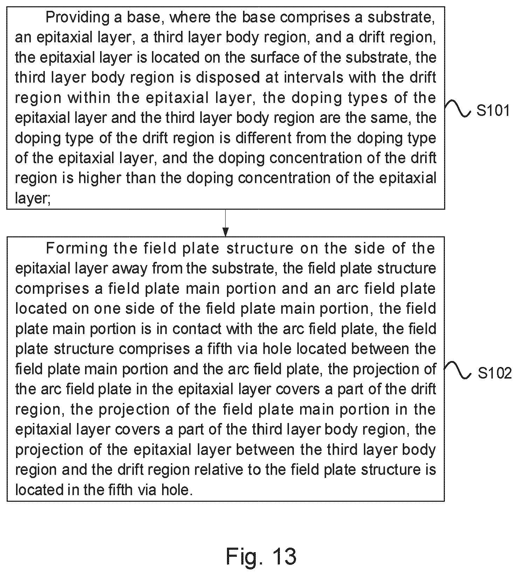

Fig. 13 is a flowchart of the manufacturing method of the LDMOS device according to the embodiment of the present disclosure. As shown in Fig. 13, the method comprises the steps of:

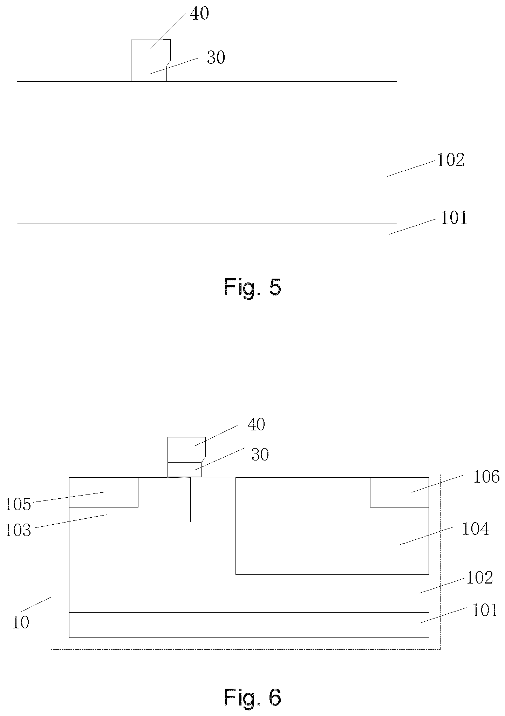

Step S101, as shown in Fig. 6, providing a base 10, where the base 10 comprises a substrate 101, an epitaxial layer 102, a third layer body region 103, and a drift region 104. The epitaxial layer 102 is located on the surface of the substrate 101. The third layer body region 103 is disposed at intervals with the drift region 104 within the epitaxial layer 102. The doping types of the epitaxial layer 102 and the third layer body region 103 are the same. The doping type of the drift region 104 is different from the doping type of the epitaxial layer 102, and the doping concentration of the drift region 104 is higher than the doping concentration of the epitaxial layer 102.

Step S102, as shown in Figs. 11 and 12, forming the field plate structure 20 on the side of the epitaxial layer 102 away from the substrate 101. The field plate structure 20 comprises a field plate main portion 201 and an arc field plate 202 located on one side of the field plate main portion 201. The field plate main portion 201 is in contact with the arc field plate 202. The field plate structure 20 comprises a fifth via hole 203 located between the field plate main portion 201 and the arc field plate 202. The projection of the arc field plate 202 in the epitaxial layer 102 covers a part of the drift region 104. The projection of the field plate main portion 201 in the epitaxial layer 102 covers a part of the third layer body region 103. The projection of the epitaxial layer 102 between the third layer body region 103 and the drift region 104 relative to the field plate structure 20 is located in the fifth via hole 203.

The manufacturing method of the LDMOS device comprises, first, providing the base, where the base comprises a substrate, an epitaxial layer, a third layer body region and a drift region, the epitaxial layer is located on a surface of the substrate, the third layer body region and the drift region are disposed within the epitaxial layer at intervals, the doping types of the epitaxial layer and the third layer body region are the same, the doping types of the drift region and the epitaxial layer are different, and the doping concentration of the drift region is larger than the doping concentration of the epitaxial layer; then, forming the field plate structure on a side of the epitaxial layer away from the substrate; where the field plate structure comprises a field plate main portion and an arc field plate located on one side of the field plate main portion, the field plate main portion is provided in contact with the arc field plate, the field plate structure has a fifth via hole, the fifth via hole is located between the field plate main portion and the arc field plate, the projection of the arc field plate in the epitaxial layer covers a part of the drift region, the projection of the field plate main portion in the epitaxial layer covers a part of the third layer body region and the drift region, and the projection of the epitaxial layer between the third layer body region the drift region relative to the field plate structure is located in the fifth via hole. Compared with the related art having poor performance because of the low breakdown voltage of the conventional device, the manufacturing method of the LDMOS device according to the present disclosure provides the base, where the base comprising the substrate, the epitaxial layer, the third layer body region, and the drift region is provided, and the field plate structure is formed on a side of the epitaxial layer away from the substrate, and the field plate structure comprises the field plate main body and the arc field plate, and the projection of the arc field plate in the epitaxial layer covers a part of the drift region, so that the electric field distribution in the drift region can be optimized by the field plate structure. In addition, since the projection of the epitaxial layer between the third layer body region and the drift region relative to the field plate structure is located in the fifth via hole, that is, the field plate structure hollows out a part of the epitaxial layer, the field plate structure has less influence on the electric field of the epitaxial layer, which further optimizes the electric field distribution of the LDMOS device, ensures that the breakdown voltage of the LDMOS device is higher, and further ensures that the performance of the semiconductor device is better.

Specifically, compared to the related art, the process of forming the base and the field plate structure does not require additional design or additional process steps. Moreover, in the manufacturing process of the LDMOS device, only by designing the hollow field plate structure, the process integration degree of the LDMOS device is high and simple.

In the embodiment, the position of the field plate structure and/or the width of the fifth via hole can be adjusted according to actual needs, so that the breakdown voltage of the LDMOS device is higher.

According to the embodiment of the present disclosure, the step of providing a base comprises: as shown in Fig. 4, providing the substrate 101 and the epitaxial layer 102 stacked thereon; as shown in Fig. 5, forming a gate oxide layer 30 on a partial surface of the epitaxial layer 102 away from the substrate 101, and forming a gate electrode 40 on a surface of the gate oxide layer 30 away from the base 10; and as shown in Fig. 6, ion implanting in the gate oxide layer 30 and the epitaxial layer 102 on two sides of the gate electrode 40, to form the third layer body region 103, the drift region 104, the source region 105, and the drain region 106. The gate oxide layer 30 covers a part of the third layer body region 103 and a part of the epitaxial layer 102, and the gate oxide layer 30 is not in contact with the source region 105. The projections of the gate oxide layer 30 and the gate electrode 40 relative to the field plate structure 20 are located in the fifth via hole 203. The source region 105 is located within the third layer body region 103. The surface of the source region 105 away from the substrate 101 is even with the surface of the epitaxial layer 102 away from the substrate 101. The doping types of the source region 105 and the third layer body region 103 are different. The drain region 106 is located within the drift region 104. The surface of the drain region 106 away from the substrate 101 is even with the surface of the drift region 104 away from the substrate 101. The doping type of the drain region 106 is the same as the doping type of the drift region 104. By providing the substrate and the epitaxial layer stacked thereon, forming the gate oxide layer on a surface of the epitaxial layer away from the substrate, forming the gate electrode on the surface of the gate oxide layer away from the epitaxial layer, and finally ion implanting on the epitaxial layer to obtain the third layer body region, the drift region, the source region and the drain region, so that the base can be obtained by a relatively simple process, and the manufacturing process of the LDMOS device is relatively simple.

In addition, since the third layer body region and the drift region are provided at intervals, and the doping concentration of the drift region is larger than the doping concentration of the epitaxial layer, the epitaxial layer having a relatively small concentration exists between the third layer body region and the drift region, and the doping types of the epitaxial layer and the drift region are different, so that the epitaxial layer and the drift region form a reverse PN junction, and the reverse PN junction can bear voltage, thereby ensuring that the good electric field distribution of the semiconductor device, the high breakdown voltage of the semiconductor device, and good performance of the semiconductor device.

In order to further ensure that the manufacturing process of the LDMOS device is relatively simple, according to another embodiment of the present disclosure, the step of forming a gate oxide layer on a partial surface of the epitaxial layer away from the substrate, and forming a gate electrode on a surface of the gate oxide layer away from the epitaxial layer, comprises: as shown in Fig. 4, forming a preliminary gate oxide layer 80 and a preliminary gate electrode 90 stacked on a surface of the epitaxial layer 102 away from the substrate 101; and as shown in Fig. 5, removing a part of the preliminary gate oxide layer 80 and a part of the preliminary gate electrode 90, where the remaining preliminary gate oxide layer 80 forms the gate oxide layer 30, and the remaining preliminary gate electrode 90 forms the gate electrode 40. By forming the preliminary gate oxide layer and the preliminary gate electrode stacked on the surface of the epitaxial layer away from the substrate, and then removing a part of the preliminary gate oxide layer and a part of the preliminary gate electrode, the gate oxide layer and the gate electrode can be obtained by a relatively simple process, and further ensuring that the manufacturing process of the LDMOS device is relatively simple.

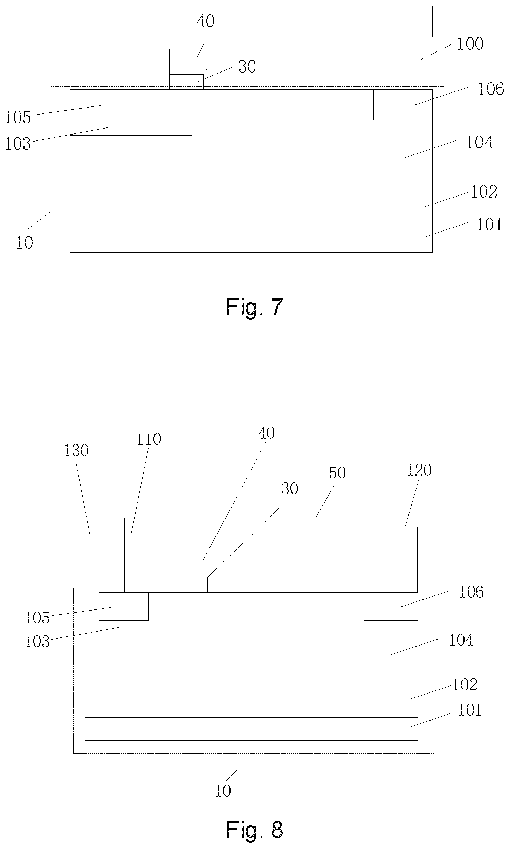

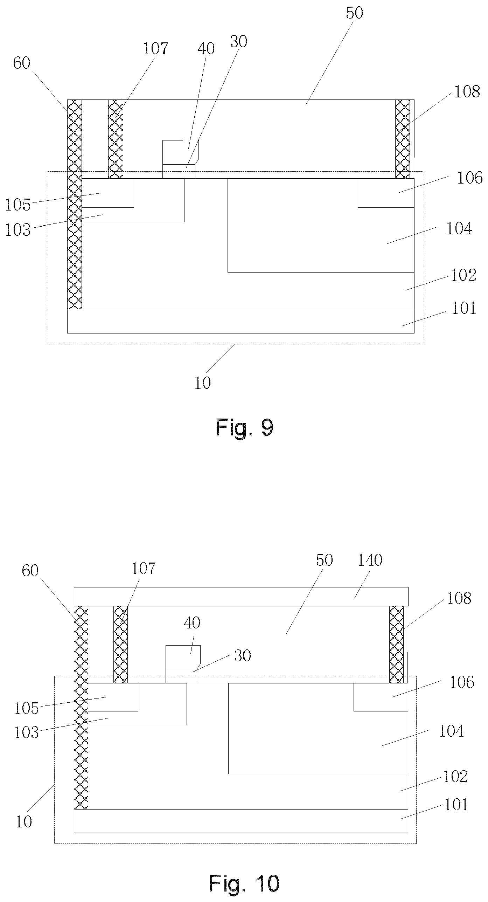

According to another specific embodiment of the present disclosure, before forming the field plate structure on the side of the epitaxial layer away from the substrate, the method further comprises as shown in Fig. 7, forming a preliminary dielectric layer 100 on the exposed surface of the epitaxial layer 102, where the surface of the preliminary dielectric layer 100 away from the epitaxial layer 102 is planar, and the field plate structure 20 is located on the surface of the preliminary dielectric layer 100 away from the base 10; as shown in Figs. 7 and 8, removing a part of the preliminary dielectric layer 100 to form a sixth via hole 110 and a seventh via hole 120, where the sixth via hole 110 and the seventh via hole 120 expose a part of the source region 105 and a part of the drain region 106 respectively; as shown in Fig. 8, removing a part of the preliminary dielectric layer 100, a part of the source region 105, a part of the third layer body region 103, and a part of the epitaxial layer 102 to form an eighth via hole 130, where the eighth via hole 130 exposes a part of the substrate 101, and the remaining preliminary dielectric layer 100 forms a dielectric layer 50; and as shown in Fig. 9, forming metal material in the sixth via hole 110, the seventh via hole 120, and the eighth via hole 130, to form a source electrode 107, a drain electrode 108, and a second metal layer 60 respectively. The second metal layer 60 electrically connects the source region 105 and the substrate 101, and the field plate structure 20 is in contact with the second metal layer 60. By forming the preliminary dielectric layer on the exposed surface of the epitaxial layer, then removing a part of the preliminary dielectric layer to form the sixth via hole and the seventh via hole, removing a part of the preliminary dielectric layer, a part of the source region, a part of the third layer body region, and a part of the epitaxial layer to form an eighth via hole, where the sixth via hole, the seventh via hole, and the eighth via hole respectively expose the source region, the drain region and the substrate, and deposing metal material in the sixth via hole, the seventh via hole, and the eighth via hole, to respectively obtain the source electrode, the drain electrode, and the second metal layer, so that the source region can be lead out via the source electrode, the drain region can be lead out via the drain electrode, and the source region and the substrate can be electrically connected via the second metal layer to realize grounding the source region, further ensuring good performance of the LDMOS device.

Specifically, the epitaxial layer is located on a part of the predetermined surface of the substrate, and the second metal layer is located on another part of the predetermined surface of the substrate.

According to the embodiment of the present disclosure, the step of forming a field plate structure on a side of the epitaxial layer away from the substrate comprises: as shown in Fig. 10, forming a preliminary field plate structure 140 on a surface of the dielectric layer 50 away from the base 10; as shown in Fig. 11, removing a part of the preliminary field plate structure 140 so that a part of the dielectric layer 50 is exposed, and the remaining preliminary field plate structure 140 forms the field plate structure 20 and a third metal layer 70 disposed at intervals, and the third metal layer 70 is in contact with the drain electrode 108. The field plate structure and the third metal layer are formed by forming the preliminary field plate structure on a surface of the dielectric layer away from the base, and by removing a part of the preliminary field plate structure. Since the field plate structure comprises the field plate main portion and the arc field plate located on one side of the field plate main portion, and the projection of the arc field plate in the epitaxial layer covers part of the drift region, the electric field distribution in the drift region can be optimized by the field plate structure. In addition, since the projection of the epitaxial layer between the third layer body region and the drift region relative to the field plate structure is located in the fifth via hole, that is, the field plate structure hollows out a part of the epitaxial layer, the field plate structure has less influence on the electric field of the epitaxial layer, which further optimizes the electric field distribution of the LDMOS device, ensures that the breakdown voltage of the LDMOS device is higher, and further ensures good performance of the semiconductor device.

Further, by forming the third metal layer and bringing the third metal layer into contact with the drain electrode, the drain region can be leas out via the third metal layer and the drain electrode, that is, the drain electrode and the drain region can be connected via the third metal layer, which further ensures good performance of the LDMOS device.

Specifically, the metal material comprises tungsten. Of course, the metal material is not limited to tungsten, and other metal materials such as copper can be selected, and is not limited here.

In the above-described embodiments of the present disclosure, the description of each embodiment has its own emphasis, and for parts not described in detail in a certain embodiment, please refer to the related description of other embodiments.

In the description of the present disclosure and embodiments thereof, it should be understood that the orientation or positional relationship indicated by the terms "top", "bottom", "height", etc. is based on the orientation or positional relationship shown in the drawings, and is only for the convenience of describing and simplifying the description of the present disclosure, and does not indicate or imply that the referred device or element must have a specific orientation, be constructed and operate in a specific orientation, and therefore cannot be understood as a limitation of the present disclosure.

In the present disclosure and embodiments thereof, unless otherwise explicitly specified and limited, terms such as "dispose", "mount", "connect", "couple", and "fix" should be understood in a broad sense, for example, they can be fixedly connected, detachably connected, or integrated. It can be a mechanical connection, an electrical connection, or a communication. It can be directly connected, or indirectly connected through an intermediate medium, or it can be the internal communication of two elements or the interaction of two elements. For those skilled in the art, the specific meanings of the above terms in the present disclosure can be understood according to specific circumstances.

In the present disclosure and embodiments thereof, unless otherwise explicitly specified and defined, a first feature being "above" or "under" a second feature may comprise that the first and second features are in direct contact, or may comprise that the first and second features are not in direct contact but are in contact by another feature therebetween. Furthermore, the first feature being "above", "over", and "upward" the second feature comprises the first feature being directly above and diagonally above the second feature, or simply indicates that the first feature is laterally higher than the second feature. The first feature being "under", "below", and "underneath" the second feature comprises that the first feature is directly above and diagonally above the second feature, or simply indicates that the first feature is laterally smaller than the second feature.

The above disclosure provides a number of different embodiments or examples for implementing different structures of the present disclosure. In order to simplify the disclosure of the present disclosure, components and arrangements of specific examples have been described above. Of course, they are merely examples and are not intended to limit the present disclosure. Furthermore, the present disclosure may repeat reference numerals and/or reference letters in different examples, such repetition being for the purpose of simplicity and clarity and not by itself indicative of relationships between the various embodiments and/or arrangements discussed. Furthermore, the present disclosure provides examples of various specific processes and materials, but those of ordinary skill in the art may recognize the application of other processes and/or the use of other materials.

Although preferred embodiments of the present disclosure have been described, additional changes and modifications may be made to these embodiments once the underlying inventive concepts have become known to those skilled in the art. Accordingly, the appended claims are intended to be construed to comprise the preferred embodiments and all alterations and modifications falling within the scope of the present disclosure.

It will be apparent that those skilled in the art can make various modifications and variations to the present disclosure without departing from the spirit and scope of the present disclosure. As such, the present disclosure is intended to comprise such modifications and variations to the present disclosure if such modifications and variations are within the scope of the claims of the present disclosure and their equivalents.

## Claims

1. An LDMOS device, comprising:
a substrate structure;
a drift region located within the substrate structure in a vertical direction;
a field plate structure located above the substrate structure in the vertical direction, a projection of a part of the field plate structure in the substrate structure covering a part of the drift region; and
a drain region located within the substrate structure in the vertical direction;
wherein at least part of the electric field lines of the drain region connected to a high voltage concentrate toward the field plate structure and terminate at the field plate structure.

2. The LDMOS device according to claim 1, wherein the field plate structure is used to prevent the voltage-bearing effect of the epitaxial layer lateral voltage-bearing region from being reduced.

3. The LDMOS device according to claim 1, wherein the drain region is formed outside the drift region in a lateral direction, and the LDMOS device further comprises:
a gate electrode, located above the substrate structure in the vertical direction and crossing an intrinsic region and a termination region of the LDMOS device in the lateral direction; and
a dielectric layer being an insulating dielectric filled between the gate electrode and the drain region;
wherein the drift region is formed outside an outer edge of the gate electrode in the lateral direction and crosses the intrinsic region and the termination region; and
the field plate structure bridges over the gate electrode and the drift region respectively in the vertical direction, surrounds an outer edge of the gate electrode, and crosses the intrinsic region and the termination region in the lateral direction.

4. The LDMOS device according to claim 3, wherein
the substrate structure comprises:
a substrate; and
an epitaxial layer, located on the substrate, wherein the drift region is formed within the epitaxial layer, the drift region and an outer edge of the gate electrode keep distance therebetween, to expose an epitaxial layer lateral voltage-bearing region, the epitaxial layer lateral voltage-bearing region is a part of the epitaxial layer located between the gate electrode and the drift region; and
the LDMOS device further comprises:
a source region, formed within the epitaxial layer in the vertical direction, and a first end side of the source region is defined as a boundary between the intrinsic region and the termination region;
wherein the epitaxial layer lateral voltage-bearing region and the outer edge of the source region keep distance therebetween, so that the epitaxial layer lateral voltage-bearing region is only located in the termination region and does not enter the intrinsic region, a side of the epitaxial layer lateral voltage-bearing region away from the source region is located below the field plate structure, and the drift region and the drain region are formed within the epitaxial layer.

5. The LDMOS device according to claim 4, wherein
the gate electrode is shaped as a running track;
the epitaxial layer lateral voltage-bearing region is shaped as a running-track surrounding the outer edge of the gate electrode located at the termination region; and
the drift region surrounds the gate electrode and an outer edge of the epitaxial layer lateral voltage-bearing region.

6. The LDMOS device according to claim 4, wherein the field plate structure comprises:
a first field plate shaped as Z;
wherein an upper lateral arm of the first field plate is disposed at intervals from an upper surface of the gate electrode, a vertical arm of the first field plate is disposed at intervals from the gate electrode, and a lower lateral arm of the first field plate is disposed at intervals from an upper surface of the drift region.

7. The LDMOS device according to claim 6, wherein the field plate structure further comprises:
a second field plate shaped as Z;
wherein an upper lateral arm of the second field plate is disposed at intervals above the upper lateral arm of the first field plate so as to be partially stacked.

8. The LDMOS device according to claim 6 or 7, further comprising:
a first layer body region and a second layer body region formed from top to bottom, wherein the doping concentrations of the first layer body region and the second layer body region increase sequentially from top to bottom; and
a body region contact region, wherein the body region contact region, the source region, and the first layer body region are disposed in a same layer in the lateral direction, and the second layer body region is formed below the body region contact region, the source region, and the first layer body region in the vertical direction.

9. The LDMOS device according to claim 8, further comprising:
a drift buffer region located within the drift region in the vertical direction and surrounding the drain region.

10. The LDMOS device according to claim 8, further comprising:
a backside metal, formed on a lower surface of the substrate;
two first metal layers, one above the source region and one above the drain region;
a first via hole and a metal filled in the first via hole connecting the source region, the body region contact region, and the first metal layer above the source region;
a second via hole and a metal filled in the second via hole connecting the drain region and the first metal layer above the drain region; and
a third via hole and a metal filled in the third via hole connecting the backside metal, the substrate, the epitaxial layer, the second layer body region and the first metal layer above the source region.

11. The LDMOS device according to claim 10, further comprising:
a fourth via hole and a metal filled in the fourth via hole connecting the first metal layer located above the source region and the upper lateral arm of the first field plate;
wherein the upper lateral arm of the first field plate is disposed at intervals from an upper surface of the gate electrode, the vertical arm of the first field plate is disposed at intervals from the gate electrode, and the lower lateral arm of the first field plate is disposed at intervals from an upper surface of the drift region.

12. The LDMOS device according to claim 11, wherein the gate electrode, the source region, and the drain region are located in a same plane.

13. The LDMOS device according to claim 1, wherein
the substrate structure comprises a substrate and an epitaxial layer;
the epitaxial layer is located on a surface of the substrate;
the LDMOS device further comprises a third layer body region, the third layer body region and the drift region are disposed at intervals within the epitaxial layer, doping types of the epitaxial layer and the third layer body region are same, doping types of the drift region and the epitaxial layer are different, and a doping concentration of the drift region is larger than a doping concentration of the epitaxial layer; and
the field plate structure comprises a field plate main portion and an arc field plate located on one side of the field plate main portion, the field plate main portion is in contact with the arc field plate, the field plate structure has a fifth via hole, the fifth via hole is located between the field plate main portion and the arc field plate, a projection of the arc field plate in the epitaxial layer covers a part of the drift region, and a projection of the epitaxial layer between the third layer body region and the drift region in the field plate structure is located in the fifth via hole.

14. The LDMOS device according to claim 13, wherein the base comprises a drain region located within the drift region, a surface of the drain region away from the substrate is even with a surface of the drift region away from the substrate, a doping type of the drain region is same as a doping type of the drift region; and
the LDMOS device further comprises:
a source region, located within the third layer body region, a surface of the source region away from the substrate being even with a surface of the epitaxial layer away from the substrate, the source region having a doping type different from the third layer body region;
a source electrode, located on a partial surface of the source region away from the substrate; and
a drain electrode, located on a partial surface of the drain region away from the substrate.

15. The LDMOS device according to claim 14, further comprising:
a gate oxide layer, located on a partial surface of the epitaxial layer, the gate oxide layer covering a part of the third layer body region and a part of the epitaxial layer, and the gate oxide layer being not in contact with the source region;
a gate electrode, located on a surface of the gate oxide layer away from the epitaxial layer, projections of the gate oxide layer and the gate electrode in the field plate structure located in the fifth via hole; and
a dielectric layer, covering the gate oxide layer, the gate electrode, and a surface of the epitaxial layer away from the substrate, wherein a surface of the dielectric layer away from the epitaxial layer is planar, the source electrode and the drain electrode penetrate the dielectric layer, and the field plate structure is located on the surface of the dielectric layer away from the substrate.

16. The LDMOS device according to claim 15, wherein the epitaxial layer is located on a partial surface of the substrate; and
the LDMOS device further comprises:
a second metal layer, located on another partial surface of the substrate, wherein a surface of the second metal layer away from the substrate is even with a surface of the dielectric layer away from the substrate, the second metal layer electrically connects the source region and the substrate, and the field plate structure is in contact with the second metal layer.

17. The LDMOS device according to claim 15, further comprising:
a third metal layer, located on a partial surface of the dielectric layer away from the substrate, wherein the third metal layer is in contact with the drain electrode, the third metal layer is disposed at intervals from the field plate structure, and the third metal layer and the field plate structure expose a part of the dielectric layer.

18. The LDMOS device according to any one of claims 13 to 17, wherein a doping type of the epitaxial layer is P-type and a doping type of the drift region is N-type.
